# FASCICULE DE BREVET EUROPEEN

(11) **EP 2 204 401 B1**
(45) Date de publication et mention de la délivrance du brevet: **31.10.2012**
(21) Numéro de dépôt: 09290970.4
(22) Date de dépôt: 18.12.2009
(51) Int. Cl.: C08J 7/18, C09D 11/00

(54) **Composition de vernis pour substrat imprimé par jet d'encre**
Lackzusammensetzung für mit Tintenstrahltinten bedruckten Substraten
Coating composition for inkjet printed substrates

(30) Priorité: 30.12.2008 FR 0807502
(43) Date de publication de la demande: 07.07.2010
(73) Titulaire: MGI FRANCE, 94200 Ivry sur Seine (FR)
(72) Inventeur: Abergel, Edmond, 75012 Paris (FR)
(74) Mandataire: Debay, Yves

(56) Documents cités:
- EP-A- 1 589 080
- WO-A-99/18134
- US-A1- 2005 261 391

## Description

La présente invention se rapporte au domaine des couches de protection pour substrats imprimés par jet d'encre et plus particulièrement au domaine des vernis déposés par jet d'encre qui ne nécessite pas un chauffage important lors de son dépôt.

Au cours d'une impression, une encre est déposée sur la surface d'un substrat, ce substrat pouvant être, par exemple, du papier ou du plastique. Il est alors courant de recouvrir la surface imprimée de ce substrat par une couche de protection. Cette couche de protection complète la fixation de l'image imprimée sur le substrat tout en garantissant la résistance de l'impression contre certaines agressions extérieures comme par exemple des projections, voire la lumière, la chaleur ou l'humidité. Le dépôt de cette couche de protection sur le substrat imprimé est généralement effectué en faisant intervenir une impression par jet d'encre. Le vernis permet aussi de personnaliser le document en faisant apparaître des zones avec des motifs en vernis et d'autres zones sans vernis.

La demande de brevet US 2005/02499895 propose un exemple d'encre de couverture déposée par jet d'encre dont la composition comprend notamment des oligomères et des monomères durcissables par radiation et au moins un photo-initiateur pour déclencher la polymérisation et donc la rigidification de la couche de couverture déposée. Ce document propose une sélection diversifiée parmi de nombreux composants pour réaliser une telle encre de couverture. Toutefois, le choix de ces composants et leur mélange est dicté dans des proportions d'oligomères et de monomères qui conduisent à l'obtention d'une encre de couverture dont la viscosité est comprise entre 15 mPa.s à 40°C et entre 8 mPa.s à 70°C. Une encre de couverture avec une telle viscosité impose un chauffage des têtes dans des plages de températures assez élevée pour éviter la prise en masse du vernis et une altération des têtes d'impressions, ces têtes d'impression étant des pièces relativement onéreuses dans les dispositifs d'impression.

La présente invention a pour objectif de palier un ou plusieurs inconvénients de l'art antérieur en fournissant une encre de couverture adaptée pour limiter les risques d'altération des têtes d'impression et fonctionnant dans des intervalles de température qui n'imposent pas un chauffage important du vernis lors de son dépôt sur le substrat imprimé.

Cet objectif est atteint grâce à un vernis pour recouvrir la surface d'un substrat imprimé et déposé par jet d'encre dont la composition du vernis comprend au moins :
- un oligomère durcissable,
- un monomère durcissable sélectionné dans un groupe intégrant des monomères acryliques alkoxylés et/ou poly-alkoxylés comprenant un ou plusieurs di ou tri-acrylates, et
- un photo-initiateur,
caractérisé en ce que l'oligomère durcissable est sélectionné dans un groupe dont la viscosité est supérieure à 1 Pa.s à 23°C, en ce que le rapport de proportion entre oligomère et monomère est compris entre 1/6 et 1/25, et en ce que le mélange des composants du vernis présente une viscosité comprise entre 15 et 22 mPa.s à 25°C et entre 5 et 2 mPa.s à 60°C, et une tension de surface comprise entre 15 et 28 mN/m à 23°C.

Selon une variante de réalisation, le vernis pour recouvrir la surface d'un substrat imprimé et déposé par jet d'encre est caractérisé en ce que l'oligomère durcissable est sélectionné dans un groupe dont la viscosité est supérieure à 1 Pa.s à 23°C, en ce que le rapport de proportion entre oligomère et monomère est compris entre 1/7 et 1/21.

Selon une variante de réalisation, le vernis pour recouvrir la surface d'un substrat imprimé et déposé par jet d'encre est caractérisé en ce que la composition du vernis comprend au moins :
- un réducteur de viscosité qui facilite l'adhésion du vernis au substrat imprimé, et/ou
- un inhibiteur de radicaux libres.

Selon une autre variante de réalisation, le vernis pour recouvrir la surface d'un substrat imprimé et déposé par jet d'encre est caractérisé en ce que le mélange des composants du vernis présente une conductivité inférieure à 1,5 µS.

Selon une première particularité de réalisation, le vernis pour recouvrir la surface d'un substrat imprimé et déposé par jet d'encre est caractérisé en ce que le photo-initiateur comprend au moins du 2-methyl-1-4-methylthiophenyl-2-4-morpholinyl-propanone.

Selon une seconde particularité de réalisation, le vernis pour recouvrir la surface d'un substrat imprimé et déposé par jet d'encre est caractérisé en ce que le photo-initiateur comprend au moins du 2-isopropyl-thioxanthone.

Selon une variante de réalisation, le vernis pour recouvrir la surface d'un substrat imprimé et déposé par jet d'encre est caractérisé en ce que le vernis comprend du N-vinylcaprolactam pour assurer l'adhésion du vernis sur la surface du substrat imprimé.

Selon une particularité de réalisation, le vernis pour recouvrir la surface d'un substrat imprimé et déposé par jet d'encre est caractérisé en ce que l'oligomère durcissable dont la viscosité est supérieure à 1 Pa.s à 23°C comprend au moins un uréthane di-acrylate aliphatique.

Selon une autre particularité de réalisation, le vernis pour recouvrir la surface d'un substrat imprimé et déposé par jet d'encre est caractérisé en ce que l'oligomère durcissable dont la viscosité est supérieure à 1 Pa.s à 23°C comprend au moins un uréthane acrylate hexa-fonctionnel.

Selon une autre particularité de réalisation, le vernis pour recouvrir la surface d'un substrat imprimé et déposé par jet d'encre est caractérisé en ce que l'oligomère durcissable dont la viscosité est supérieure à 1 Pa.s à 23°C comprend au moins un époxy di-acrylate bisphénol A.

Selon une variante de réalisation, le vernis pour recouvrir la surface d'un substrat imprimé et déposé par jet d'encre est caractérisé en ce que la composition du vernis comprend au moins un additif avec une granulométrie inférieure à 50 µm, cet additif étant :
- un agent mâtant pour l'obtention d'un vernis mât ou satin, et/ou
- des paillettes pour l'obtention d'un vernis pailleté, et/ou
- de pigments et/ou colorants pour l'obtention d'un vernis coloré, et/ou
- de pigments et/ou colorants fluorescents pour l'obtention d'un vernis fluorescent, et/ou
- de pigments et/ou colorants sensible à la lumière noire pour l'obtention d'un vernis à effet optique.

Selon une variante de réalisation, le vernis pour recouvrir la surface d'un substrat imprimé et déposé par jet d'encre est caractérisé en ce que la composition du vernis comprend une granulométrie adaptée pour le passage dans une buse lors d'un dépôt par jet d'encre sur le substrat imprimé.

Un autre objectif de l'invention est de proposer un procédé pour permettre la production d'un vernis selon l'invention.

Cet objectif est atteint grâce à un procédé de production d'un vernis pour recouvrir la surface d'un substrat imprimé et déposé par jet d'encre,
caractérisé en ce que le procédé comprend :
- une étape de mélange du réducteur de viscosité avec l'inhibiteur de radicaux libres, d'un photo-initiateur à une température comprise entre 150 et 300°C,
- une étape de refroidissement du mélange jusqu'à une température ambiante,
- une étape d'ajout sous agitation d'au moins une oligomère durcissable selon la composition du vernis, d'au moins un monomère durcissable selon la composition du vernis.

Selon une particularité de réalisation, le procédé de production d'un vernis pour recouvrir la surface d'un substrat imprimé et déposé par jet d'encre est caractérisé en ce que le procédé comprend :
- une étape de filtration du mélange obtenu selon une granulométrie adaptée pour le passage dans une buse lors d'un dépôt par jet d'encre sur le substrat imprimé.

L'invention, avec ses caractéristiques et avantages, ressortira plus clairement à la lecture de la description faite en référence aux dessins annexés dans lesquels :

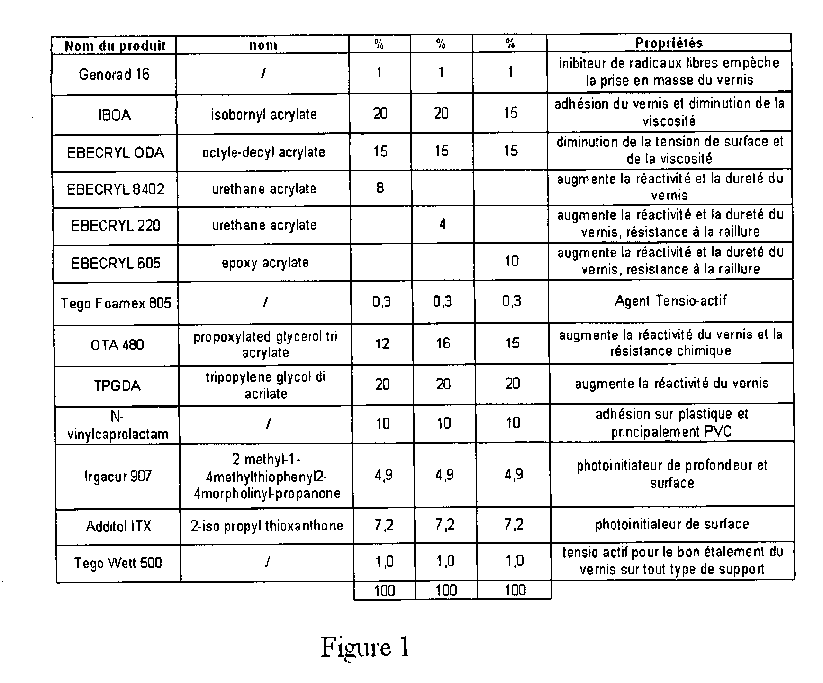

- la figure 1 représente un tableau établissant la composition de trois vernis selon l'invention,

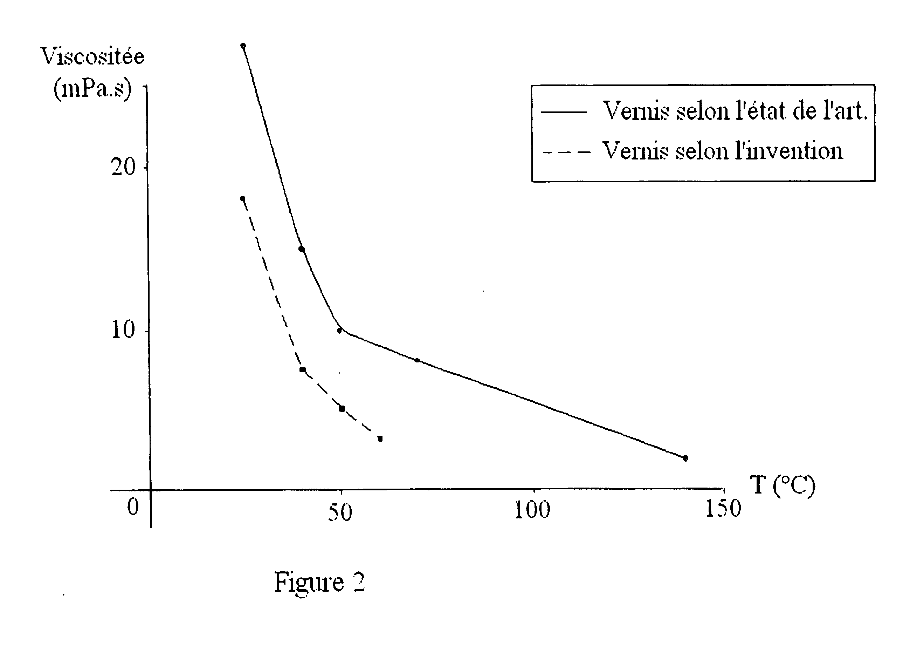

- la figure 2 représente une comparaison de la viscosité en fonction de la température d'un vernis selon l'invention avec celle d'une encre de protection selon l'art antérieur.

Il convient de signaler que les molécules citées dans le présent document ne sont pas limitatives de la composition du vernis de l'invention, mais sont illustratives de molécules, monomères ou polymères qui possèdent ou présentent des caractéristiques, des propriétés ou des fonctions identiques ou similaires.

La présente invention porte sur un vernis de protection destiné à recouvrir la surface d'un substrat imprimé. Ce vernis est réalisé sans solvant comprend dans sa composition au moins un oligomère durcissable sélectionné dans un groupe dont la viscosité est supérieure à 1 Pa.s à 23°C, un monomère durcissable sélectionné dans un groupe intégrant des monomères acryliques alkoxylés et/ou poly-alkoxylés comprenant un ou plusieurs di ou tri-acrylates, et un photo-initiateur de surface.

Il est important que le choix de l'oligomère ou du mélange d'oligomères s'opère au sein d'un groupe dont les composants présentent une viscosité supérieure à 1 Pa.s à 23°C. Selon un mode de réalisation préférentielle, cette viscosité est supérieure à 1 Pa.s à cette température de 23°C. En effet, le mélange d'oligomères a pour objet d'augmenter la réactivité de la composition du vernis et la résistance chimique et physique de celui-ci, comme par exemple à la rayure. Cet oligomère est associé dans la composition du vernis avec différents monomères qui participent à d'autres propriétés du vernis. Selon le type d'oligomère utilisé et le niveau de viscosité recherchée pour le vernis, le rapport entre oligomère et monomère dans la composition présente une valeur comprise entre 1/6 et 1/25. Selon une mode de réalisation préféré de la composition du vernis, la valeur de ce rapport se situe préférentiellement entre 1/7 et 1/21.

Selon le type de vernis recherché, c'est-à-dire selon le type de caractéristiques physiques souhaitées en fonction du substrat à recouvrir, le choix de l'oligomère vient à différer. Toutefois, la viscosité de l'oligomère est comprise entre 5 et 45 Pa.s, voire préférentiellement entre 12 et 29 Pa.s à 25°C. Dans le cas d'une polymérisation où un séchage rapide est nécessaire pour l'obtention d'un vernis qui présente une dureté ou une rigidité adaptée pour un dépôt sur un substrat formé par une surface plastique sensiblement rigide, l'oligomère choisi est un uréthane acrylate hexa-fonctionnel, disponible par exemple sous l'appellation EBECRYL 1290 ou EBECRYL 5129. Cet oligomère est communément disponible sous l'appellation EBECRYL 220 et présente une viscosité de l'ordre de 28,5 Pa.s à 25°C. L'EBECRYL 220 est un uréthane acrylate aromatique hexa-fonctionnel, tandis que les EBECRYL 1290 et EBECRYL 5129 sont des uréthanes acrylate aliphatique hexa-fonctionnel. L'uréthane acrylate hexa-fonctionnel peut, selon les cas, être remplacé par un époxy di-acrylate bisphénol A disponible sous la référence EBECRYL 605 qui présente une viscosité de l'ordre de 7,5 Pa.s à 25°C. En revanche, lorsque le vernis est destiné à être déposé sur un substrat plus souple, tel que du papier, l'oligomère qui est préféré comme oligomère principal du mélange est un uréthane di-acrylate aliphatique. Cet oligomère est facilement disponible sous la dénomination EBECRYL 8402 et présente une viscosité de l'ordre de 12,5 Pa.s à 25°C. Avec l'utilisation de cet oligomère, le vernis obtenu présente une souplesse supérieure à celle d'un vernis obtenu avec un époxy di-acrylate bisphénol A, qui lui-même montre une rigidité inférieure à celle d'un vernis obtenu avec un uréthane acrylate hexa-fonctionnel.

La souplesse et la rigidité du vernis est également fonction du rapport entre oligomère et monomère dans la composition. Ainsi, un époxy di-acrylate bisphénol A est utilisé avec un rapport oligomère/monomère qui présente une valeur comprise entre 1/6 et 1/9. Préférentiellement, cette valeur est comprise entre 1/7 et 1/8, et de façon optimale cette valeur est de l'ordre de 1/7,5. Lorsque l'oligomère utilisée est un uréthane acrylate hexa-fonctionnel, le mélange est réalisé avec un rapport entre oligomère et monomère bien plus faible puisqu'il présente une valeur comprise entre 1/15 et 1/25. Préférentiellement, cette valeur est située dans un intervalle compris entre 1/19 et 1/22, voire de façon optimale, est de l'ordre de 1/20,5. L'utilisation d'un uréthane acrylate hexa-fonctionnel nécessite donc une quantité plus restreinte de composant durcisseur dans le vernis comparé à un époxy di-acrylate bisphénol A. Dans le cas d'une utilisation d'un uréthane di-acrylate aliphatique, le rapport entre oligomère et monomère montre une valeur comprise entre 1/8 et 1/12. Cette valeur est préférentiellement située dans un intervalle de valeurs comprises entre 1/9 et 1/11, pour avoir de façon optimale une valeur de 1/10.

Il peut être envisagé des mélanges d'oligomères, et notamment des mélanges rassemblant les différents oligomères cités précédemment, de sorte que la composition du mélange permette l'obtention d'un vernis avec des propriétés communes voire intermédiaires entre les vernis souples et les vernis dures. Ces vernis « intermédiaires » allient ainsi souplesse et résistance à d'éventuelles agressions.

Les monomères qui complètent la composition du vernis, en plus de présenter des capacités de durcissement, pour certains d'entre eux, sont sélectionnés par rapport à leurs propriétés. Ainsi, certains monomères permettant d'augmenter la réactivité du vernis sont utilisés comme par exemple le tripopylène-glycol-di-acrylate ou le propoxylated-glycerol-tri-acrylate, respectivement connu sous les dénominations TPGDA et OTA 480. Ce dernier composant possède également comme propriété d'apporter une résistance chimique au mélange. D'autres monomères sont utilisés pour permettre une réduction de la viscosité du vernis. Ces monomères sont, par exemple, l'octyle-decyl-acrylate et l'isobornyl-acrylate, respectivement connus sont les noms de EBECRYL ODA et IBOA. L'octyle-decyl-acrylate a également pour propriété de restreindre les tensions de surface dans le mélange. De même, l'utilisation de l'isobornyl-acrylate permet de faciliter l'adhérence du vernis au cours de son dépôt sur la surface du substrat. L'adhérence sur des surfaces sensiblement rigides comme des plastiques ou des PVC (polychlorures de vinyle) peut être améliorée par l'utilisation du N-vinylcaprolactame comme un des monomères qui entrent dans la composition du vernis.

Afin d'obtenir un étalement optimal du vernis sur la surface du support imprimé, la composition du vernis intègre un tensio-actif qui peut, par exemple, être le mélange répertorié sous le nom Tego Wett 500. D'autres agents tensio-actifs peuvent être utilisés tels que, par exemple et de façon non limitative, le polyéther siloxane, l'alcool alkoxylé, un fluoro-surfactant, ou encore un surfactant « sans silicone ».

La réaction de polymérisation lorsque le vernis est projeté sur la surface du substrat, est initiée par au moins un photo-initiateur qui peut être de profondeur ou de surface. Ces photo-initiateurs sont, par exemple, l'Additol ITX et/ou l'Irgacure 907, qui correspondent respectivement au 2-isopropyl-thioxanthone et au 2-methyl-1-4-methylthiophenyl-2-4-morpholinyl-propanone. Ces photo-initiateurs permettent le déclenchement de la réaction de polymérisation du vernis uniquement en présence d'un rayonnement UV. Les pics d'absorption utilisés pour assurer la formation de radicaux libres qui initient la polymérisation du vernis présentent généralement une longueur d'onde de l'ordre de 300 à 390 nm pour l'Additol ITX et une longueur d'onde de l'ordre de 230 à 304 nm pour l'Irgacure 907. Ce rayonnement peut-être assuré, par exemple, grâce à un dispositif disposé dans le système d'impression qui utilise le vernis. D'autres pourraient être utilisés tels que, par exemple et de manière non limitative, la benzo-phénone, la 2,4,6-tri-méthyl-benzoyl-di-phényl phosphine oxide, la 1-hydroxy-cyclo-héxyl-phényl-ketone, la iso-propyl-thioxanthone, la n-méthyle-diéthanolamine, ou encore le di-phényl (2,4,6-tri-méthyle-benzoyl)-phosphine oxide.

Afin d'éviter une prise en masse du vernis sous l'action de la chaleur dans des conditions non-désirées, le vernis intègre un antioxydant qui joue le rôle d'inhibiteur de radicaux libres. Cette inhibition peut être assurée, par exemple, en intégrant dans la composition un mélange référencé sous le nom de Genorad 16 ou d'Additol S110.

Les différents composants qui permettent la réalisation du vernis de l'invention sont mélangés dans des proportions déterminées. Ainsi, on a :
- l'inhibiteur, Genorad 16, qui est présent dans une proportion de 0,1 à 2,0%, préférentiellement dans une proportion de 1,0% du mélange final,
- le tensioactif, Tego Wett 500, qui est présent dans une proportion de 0,1 à 2,0%, préférentiellement dans une proportion de 1,0% du mélange final,
- les photo-initiateurs de surface sont présent dans une proportion de 8 à 15%, préférentiellement dans une proportion de 12%, avec respectivement de l'Additol ITX dans une proportion de 4,0 à 10,0%, préférentiellement 7,2% et de l'Irgacure 907 dans une proportion de 2,0 à 4,9%, préférentiellement 4,9% du mélange final,
- le monomère de fonction qui assure l'adhésion au support, c'est-à-dire le N-vinylcaprolactam, est présent dans une proportion de 8 à 15%, préférentiellement dans une proportion de 10% du mélange final,
- le monomère de fonction qui améliore la réactivité du mélange, c'est-à-dire le tripopylène-glycol-di-acrylate, est présent dans une proportion de 15 à 25%, préférentiellement dans une proportion de 20% du mélange final,
- le monomère de fonction qui permet la réduction de la tension de surface et de la viscosité, c'est-à-dire l'EBECRYL ODA, est présent dans une proportion de 12 à 18%, préférentiellement dans une proportion de 15% du mélange final.

L'ensemble des composants que sont l'oligomère ou mélange d'oligomères, le monomère de fonction activateur de réaction qu'est l'OTA 480, et le monomère de fonction qui accroit l'adhérence qu'est l'IBOA, forment un mélange qui représente 25 à 35% de la composition finale, préférentiellement 30%. Les proportions tendent à être modifiées en fonction du type d'oligomère ou des types d'oligomères sélectionnées pour entrer dans la composition du vernis de l'invention.

Lorsque l'oligomère sélectionnée est un époxy di-acrylate bisphénol A, celui représente environ 8 à 15% du mélange final, préférentiellement 10%, l'OTA 480 et l'IBOA sont, eux, présents dans des proportions de l'ordre de 12-18% du mélange finale, préférentiellement 15%. En revanche, lorsque l'oligomère choisi est un uréthane acrylate hexa-fonctionnel ou un uréthane di-acrylate aliphatique, l'IBOA représente environ 15 à 25% du mélange final, préférentiellement 20%. Cependant, dans le cas où l'oligomère est un uréthane di-acrylate aliphatique, l'oligomère et l'OTA 480 représentent respectivement 5 à 15% du mélange final, préférentiellement 8% et 10 à 15% du mélange final, préférentiellement 12%. De même, lorsque l'oligomère est un uréthane acrylate hexa-fonctionnel, les proportions sont modifiées de sorte que l'oligomère et l'OTA 480 représentent respectivement 2 à 5% du mélange final, préférentiellement 4% et 15 à 18% du mélange final, préférentiellement 16%.

Selon le type de vernis qu'on souhaite réaliser, des éléments additionnels peuvent être ajoutés aux composants. Ainsi, pour la conception de vernis mât ou satin, des agents mâtant peuvent être apportés au mélange. Pour l'obtention d'un vernis pailleté, on ajoutera des paillettes ; pour la conception de vernis colorés, on rajoutera des pigments ou des colorants de couleurs souhaitées, ces pigments pouvant également être fluorescents voire sensible à la lumière noire pour l'obtention de vernis particulier.

Le vernis peut intégrer dans sa composition au moins une résine choisie parmi les résines acryliques, vinyliques, cétoniques, polyesters, et aldéhydes. Cette résine est ajoutée dans la composition dans une proportion de l'ordre de 5 à 10% du mélange finale. Le choix de la résine est fonction du support et selon le résultat recherché. Ces résines ont comme propriétés d'améliorer la résistance chimique de la composition finale et la résistance mécanique du vernis déposé. Un exemple de résine vinylique susceptible d'apporter des propriétés d'adhérence au substrat peut être la résine connu sous la référence VYHH

La production du vernis selon l'invention est opérée en effectuant successivement :
- une étape de mélange du réducteur de viscosité avec l'inhibiteur de radicaux libres et un photo-initiateur à une température comprise entre 150 et 300°C selon la vitesse du mélange désirée,
- une étape de refroidissement du mélange jusqu'à une température ambiante,
- une étape d'ajout sous agitation d'au moins une oligomère durcissable selon la composition du vernis, et/ou d'au moins un monomère durcissable selon la composition du vernis, ainsi que de tout autre élément entrant dans la composition du vernis.

Selon un mode opératoire préféré, l'agent tensio-actif est ajouté en dernier pour éviter la formation de mousses lors de l'agitation des composants en cours de mélange. Pour limiter cette apparition de mousses, des agents démoussants peuvent être ajoutés dans le mélange, tels que du polyéther siloxane. Cet agent dé-moussant ou anti-mousse est ainsi ajouté dans une proportion de 0,1 à 1,0%, préférentiellement 0,3%. Un exemple d'agent tensio-actif susceptible d'être utilisé est le Tego Foamex 805. La tension de surface du mélange obtenue présente alors une valeur comprise entre 15 à 28 mN/m à 23°C, préférentiellement entre 20 à 28 mN/m à 23°C.

Le mélange obtenu présente une conductivité inférieure à 1,5 µS, préférentiellement inférieure à 0,8 µS, idéalement 0,1 µS.

Le procédé de production peut également comprendre une étape de filtration du mélange obtenu selon une granulométrie adaptée pour le passage dans une buse lors d'un dépôt par jet d'encre sur le substrat imprimé. Le dépôt par jet d'encre peut s'opérer soit par la technique connue, dite « *Bubble Jet* » de projection de l'encre contenue dans une buse par une surpression crée par une bulle gazeuse formée au niveau d'une résistance de chauffage, soit par une autre technique connue qui consiste à former une surpression en utilisant un composant piézo-électrique qui va s'incurver sous l'effet d'une tension électrique pour réduire le volume du réservoir d'encre. En effet, la projection du vernis s'opérant par l'intermédiaire d'une buse, il est impératif que la granulométrie des composants du vernis n'entraine pas une obstruction de la buse. Ainsi, la filtration est réalisée à 10 µm, préférentiellement à 5 µm et de façon optimale à 1 µm.

Selon un mode opératoire préféré, mais qui n'est pas limitatif de l'invention, la détermination des paramètres physiques des composants ou de la composition de la demande est opérée aux températures indiquées et dans des conditions de pressions habituelles à la surface terrestre, préférentiellement de l'ordre d'une atmosphère (1013 mBar). C'est ainsi que la viscosité peut être mesurée à l'aide d'un viscosimètre HAAKE Viscotester 550 équipé d'un Cup NV et d'un Rotor NV qui sont des instruments de mesure connus, commercialisé par la société ThermoFisher, faisant intervenir un système de régulation de température, branché sur un bain thermostaté, maintient l'échantillon de vernis à une température de 25°C. De même, la tension de surface est mesurée à l'aide d'un tensiomètre DSA 100 avec la méthode de la goutte pendante, commercialisé par la société KRÜSS. Les granulométrie et conductivité sont respectivement mesurées à l'aide d'une part d'un appareil de mesure de taille de particules appelé MASTERSIZER 2000, commercialisé par la société MALVERN, et d'autre part d'un conductimètre CYBERSCAN CON 11 de EUTECH INSTRUMENTS avec une cellule de mesure de référence ECCONSEN91W/35608-50 dont la constante de cellule est de K=1.0.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration mais peuvent être modifiés dans le domaine défini par la portée des revendications jointes.

## Revendications

1. Vernis pour recouvrir la surface d'un substrat imprimé et déposé par jet d'encre dont la composition du vernis comprend au moins :
- au moins un oligomère durcissable,
- au moins un monomère durcissable sélectionné dans un groupe intégrant des monomères acryliques alkoxylés et/ou poly-alkoxylés comprenant un ou plusieurs di ou tri-acrylates, et
- au moins un photo-initiateur,
**caractérisé en ce que** l'oligomère durcissable est sélectionné dans un groupe dont la viscosité est supérieure à 1 Pa.s à 23°C, **en ce que** le rapport de proportion entre oligomère et monomère est compris entre 1/6 et 1/25, et **en ce que** le mélange des composants du vernis présente une viscosité comprise entre 15 et 22 mPa.s à 25°C et entre 5 et 2 mPa.s à 60°C, et une tension de surface comprise entre 15 et 28 mN/m à 23°C, la viscosité étant mesurée par un viscosimètre avec une coupelle de mesure et un rotor et faisant intervenir un système de régulation de température branché sur un bain thermostaté.

2. Vernis pour recouvrir la surface d'un substrat imprimé et déposé par jet d'encre selon la revendication 1, **caractérisé en ce que** l'oligomère durcissable est sélectionné dans un groupe dont la viscosité est supérieure à 1 Pa.s à 23°C, **en ce que** le rapport de proportion entre oligomère et monomère est compris entre 1/7 et 1/21.

3. Vernis pour recouvrir la surface d'un substrat imprimé et déposé par jet d'encre selon l'une des revendications 1 et 2, **caractérisé en ce que** la composition du vernis comprend au moins :
- un réducteur de viscosité qui facilite l'adhésion du vernis au substrat imprimé, et/ou
- un inhibiteur de radicaux libres.

4. Vernis pour recouvrir la surface d'un substrat imprimé et déposé par jet d'encre selon la revendication 1 à 3, **caractérisé en ce que** le mélange des composants du vernis présente une conductivité inférieure à 1,5 µS mesurée par un conductimètre dont la cellule de mesure de référence présente une constante de mesure de K=1.0.

5. Vernis pour recouvrir la surface d'un substrat imprimé et déposé par jet d'encre selon une des revendications 1 à 4, **caractérisé en ce que** le photo-initiateur comprend au moins du 2-methyl-1-4-methylthiophenyl-2-4-morpholinyl-propanone.

6. Vernis pour recouvrir la surface d'un substrat imprimé et déposé par jet d'encre selon une des revendications 1 à 4, **caractérisé en ce que** le photo-initiateur comprend au moins du 2-isopropyl-thioxanthone.

7. Vernis pour recouvrir la surface d'un substrat imprimé et déposé par jet d'encre selon une des revendications précédentes, **caractérisé en ce que** le vernis comprend du N-vinylcaprolactam pour assurer l'adhésion du vernis sur la surface du substrat imprimé.

8. Vernis pour recouvrir la surface d'un substrat imprimé et déposé par jet d'encre selon une des revendications précédentes, **caractérisé en ce que** l'oligomère durcissable dont la viscosité est supérieure à 1 Pa.s à 23°C comprend au moins un uréthane di-acrylate aliphatique.

9. Vernis pour recouvrir la surface d'un substrat imprimé et déposé par jet d'encre selon une des revendications précédentes, **caractérisé en ce que** l'oligomère durcissable dont la viscosité est supérieure à 1 Pa.s à 23°C comprend au moins un uréthane acrylate hexa-fonctionnel.

10. Vernis pour recouvrir la surface d'un substrat imprimé et déposé par jet d'encre selon une des revendications précédentes, **caractérisé en ce que** l'oligomère durcissable dont la viscosité est supérieure à 1 Pa.s à 23°C comprend au moins un époxy di-acrylate bisphénol A.

11. Vernis pour recouvrir la surface d'un substrat imprimé et déposé par jet d'encre selon une des revendications précédentes, **caractérisé en ce que** la composition du vernis comprend au moins un additif avec une granulométrie inférieure à 50 µm, cet additif étant :
- un agent mâtant pour l'obtention d'un vernis mât ou satin, et/ou
- des paillettes pour l'obtention d'un vernis pailleté, et/ou
- de pigments et/ou colorants pour l'obtention d'un vernis coloré, et/ou
- de pigments et/ou colorants fluorescents pour l'obtention d'un vernis fluorescent, et/ou
- de pigments et/ou colorants sensible à la lumière noire pour l'obtention d'un vernis à effet optique.

12. Vernis pour recouvrir la surface d'un substrat imprimé et déposé par jet d'encre selon une des revendications précédentes, **caractérisé en ce que** la composition du vernis comprend une granulométrie adaptée pour le passage dans une buse lors d'un dépôt par jet d'encre sur le substrat imprimé.

13. Procédé de production d'un vernis pour recouvrir la surface d'un substrat imprimé et déposé par jet d'encre selon une des revendications 2 à 12, **caractérisé en ce que** le procédé comprend :
- une étape de mélange du réducteur de viscosité avec l'inhibiteur de radicaux libres et un photo-initiateur à une température comprise entre 150 et 300°C,
- une étape de refroidissement du mélange jusqu'à une température ambiante,
- une étape d'ajout sous agitation d'au moins une oligomère durcissable selon la composition du vernis, d'au moins un monomère durcissable selon la composition du vernis.

14. Procédé de production d'un vernis pour recouvrir la surface d'un substrat imprimé et déposé par jet d'encre selon la revendication 13, **caractérisé en ce que** le procédé comprend :
- une étape de filtration du mélange obtenu selon une granulométrie adaptée pour le passage dans une buse lors d'un dépôt par jet d'encre sur le substrat imprimé.

## Claims

1. Varnish for covering the surface of a printed substrate and deposited by inkjet, the composition of the varnish comprising at least:
- at least one hardenable oligomer,
- at least one hardenable monomer selected from within a group including alkoxylated and/or poly-alkoxylated acrylic monomers comprising one or more di- or tri-acrylates, and
- at least one photoinitiator,
**characterised in that** the hardenable oligomer is selected from within a group of which the viscosity is greater than 1 Pa.s at 23 °C, **in that** the ratio between oligomer and monomer is between 1/6 and 1/25, and **in that** the mixture of constituents of the coating has a viscosity between 15 and 22 mPa.s at 25 °C and between 5 and 2 mPa.s at 60 °C, and a surface tension between 15 and 28 mN/m at 23 °C, the viscosity being measured by a viscometer with a measuring cup and a rotor and using a temperature regulation system connected to a thermostat-controlled bath.

2. Varnish for covering the surface of a printed substrate and deposited by inkjet a claimed in Claim 1, **characterised in that** the hardenable oligomer is selected from within a group of which the viscosity is greater than 1 Pa.s at 23 °C, and **in that** the ratio between oligomer and monomer is between 1/7 and 1/21.

3. Varnish for covering the surface of a printed substrate and deposited by inkjet as claimed in any one of Claims 1 and 2, **characterised in that** the composition of the varnish comprises at least:
- a viscosity reducer which facilitates adhesion of the varnish to a printed substrate, and/or
- an inhibitor of free radicals.

4. Varnish for covering the surface of a printed substrate and deposited by inkjet as claimed in any one of Claims 1 and 3, **characterised in that** the mixture of components of the varnish has a conductivity less than 1.5 Ps measured by a conductivity meter of which the reference measurement cell has a measurement constant of K=1.0.

5. Varnish for covering the surface of a printed substrate and deposited by inkjet as claimed in any one of Claims 1 to 4, **characterised in that** the photoinitiator comprises at least 2-methyl-1-4-methylthiophenyl-2-4-morpholinyl-propanone.

6. Varnish for covering the surface of a printed substrate and deposited by inkjet as claimed in any one of Claims 1 to 4, **characterised in that** the photoinitiator comprises at least 2-isopropyl-thioxanthone.

7. Varnish for covering the surface of a printed substrate and deposited by inkjet as claimed in any one of the preceding claims, **characterised in that** the varnish comprises N-vinylcaprolactam to ensure the adhesion of the varnish on the surface of the printed substrate.

8. Varnish for covering the surface of a printed substrate and deposited by inkjet as claimed in any one of the preceding claims, **characterised in that** the hardenable oligomer having a viscosity greater than 1 Pa.s at 23 °C includes aliphatic urethane di-acrylate.

9. Varnish for covering the surface of a printed substrate and deposited by inkjet as claimed in any one of the preceding claims, **characterised in that** the hardenable oligomer having a viscosity greater than 1 Pa.s at 23 °C comprises at least one hexa-functional urethane acrylate.

10. Varnish for covering the surface of a printed substrate and deposited by inkjet as claimed in ant of the preceding claims, **characterised in that** the hardenable oligomer having a viscosity greater than 1 Pa.s at 23 °C comprises at least one bisphenol A epoxy di-acrylate.

11. Varnish for covering the surface of a printed substrate and deposited by inkjet as claimed in any one of the preceding claims, **characterised in that** the composition of the varnish comprises at least one additive with a particle size of less than 50 µm, this additive being:
- a matting agent for obtaining a matt or satin varnish, and/or
- flakes for obtaining a flaked varnish, and/or
- pigments and/or colorants for obtaining a coloured varnish, and/or
- pigments and/or fluorescent colorants for obtaining a fluorescent varnish, and/or
- pigments and/or colorants sensitive to black light for obtaining a varnish with an optical effect.

12. Varnish for covering the surface of a printed substrate and deposited by inkjet as claimed in any one of the preceding claims, **characterised in that** the composition has a particle size adapted for passing through a nozzle during deposition by inkjet on the printed substrate.

13. Method of production of a varnish for covering the surface of a printed substrate and deposited by inkjet as claimed in any one of Claims 2 to 12, **characterised in that** the method comprises:
- a step of mixing the viscosity reducer with the inhibitor of free radicals and a photoinitiator at a temperature between 150 and 300 °C,
- a step of cooling the mixture to an ambient temperature,
- a step of adding under agitation at least one hardenable oligomer according to the composition of the varnish, and at least one hardenable monomer according to the composition of the varnish.

14. Method of production of a varnish for covering the surface of a printed substrate and deposited by inkjet as claimed in Claim 13, **characterised in that** the method comprises:
- a step of filtration of the mixture obtained according to a particle size adapted for passing through a nozzle during deposition by inkjet on the printed substrate.

## Patentansprüche

1. Firnis zum Bedecken der Oberfläche eines bedruckten Substrats, der mit einem Tintenstrahl abgelagert wird, wobei die Zusammensetzung des Firnis zumindest enthält:
zumindest ein härtbares Oligomer,
zumindest ein härtbares Monomer, das gewählt ist aus einer Gruppe, die einen oder mehrere Triacrylate enthaltende akrylische Alkoxy- und/oder Polyalkoxy-Monomere enthält, und
zumindest einen Fotoinitiator,
**dadurch gekennzeichnet, dass** das härtbare Oligomer gewählt ist aus einer Gruppe, deren Viskosität bei 23°C größer als 1 Pa.s ist, und
dadurch, dass das Verhältnis der Anteile von Oligomer zu Monomer zwischen 1/6 und 1/25 liegt, und
dadurch, dass die Mischung der Komponenten des Firnis eine Viskosität aufweist, die bei 25°C zwischen 15 und 22 mPa.s und bei 60°C, zwischen 5 und 2 mPa.s liegt, sowie eine Oberflächenspannung, die bei 23°C zwischen 15 und 28 mN/m liegt, wobei die Viskosität durch ein Viskosimeter mit einem Messschälchen und einem Rotor gemessen wird und ein System zur Temperaturregelung eingreifen lässt, das an ein thermostabilisierte Bad angeschlossen ist.

2. Firnis zum Bedecken der Oberfläche eines bedruckten Substrats, der mit einem Tintenstrahl abgelagert wind, gemäß Anspruch 1, **dadurch gekennzeichnet, dass** das härtbare Oligomer, gewählt ist aus einer Gruppe, deren Viskosität bei 23°C größer als 1 Pa.s ist, und
dadurch, dass das Verhältnis der Anteile von Oligomer, zu Monomer zwischen 1/7 und 1/21 liegt.

3. Firnis zum Bedecken der Oberfläche eines bedruckten Substrats, der mit einem Tintenstrahl abgelagert wird, gemäß einem der Ansprüche 1 und 2, **dadurch gekennzeichnet, dass** die Zusammensetzung des Firnis zumindest enthält:
ein Viskositätsreduziermittel, das das Anhaften des Firnis an dem bedruckten Substrat erleichtert, und/oder
einen Hemmstoff für freie Radikale.

4. Firnis zum Bedecken der Oberfläche eines bedruckten Substrats, der mit einem Tintenstrahl abgelagert wird, gemäß einem der Ansprüche 1 bis 3, **dadurch gekennzeichnet, dass** die Mischung der Komponenten des Firnis eine Leitfähigkeit von weniger als 1,5 µS aufweist, gemessen durch ein Leitfähigkeitsmessgerät, dessen Referenzmesszelle eine Messkonstante von K=1.0 aufweist.

5. Firnis zum Bedecken der Oberfläche eines bedruckten Substrats, der mit einem Tintenstrahl abgelagert wird, gemäß einem der Ansprüche 1 bis 4, **dadurch gekennzeichnet, dass** der Fotoinitiator zumindest 2-Methyl-1-4-methylthiophenyl-2-4-morpholinyl-propanon enthält.

6. Firnis zum Bedecken der Oberfläche eines bedruckten Substrats, der mit einem Tintenstrahl abgelagert wird, gemäß einem der Ansprüche 1 bis 4, dadurch gekenntzeichnet, dass der Fotoinitiator zumindest 2-Isopropyl-thioxanthon enthält.

7. Firnis zum Bedecken der Oberfläche eines bedruckten Substrats, der mit einem Tintenstrahl abgelagert wird, gemäß einem der vorigen Ansprüche, dadurch gekenntzeichnet, dass der Firnis N-Vinylcaprolactam enthält, um das das Anhaften des Firnis an dem bedruckten Substrat sicherzustellen.

8. Firnis zum Bedecken der Oberfläche eines bedruckten Substrats, der mit einem Tintenstrahl abgelagert wird, gemäß einem der vorigen Ansprüche, **dadurch gekennzeichnet, dass** das härtbare Oligomer, dessen Viskosität bei 23°C größer als 1 Pa.s ist, zumindest ein aliphatisches Urethan-Diacrylat enthält.

9. Firnis zum Bedecken der Oberfläche eines bedruckten Substrats, der mit einem Tintenstrahl abgelagert wird, gemäß einem der vorigen Ansprüche, **dadurch gekennzeichnet, dass** das härtbare Oligomer, dessen Viskosität bei 23°C größer als 1 Pa.s ist, zumindest ein hexa-funktionelles Urethan-Acrylat enthält.

10. Firnis zum Bedecken der Oberfläche eines bedruckten Substrats, der mit einem Tintenstrahl abgelagert wird, gemäß einem der vorigen Ansprüche, **dadurch gekennzeichnet, dass** das härtbare Oligomer, dessen Viskosität bei 23°C größer als 1 Pa.s ist, zumindest ein Epoxy-Diacrylat Bisphenol A enthält.

11. Firnis zum Bedecken der Oberfläche eines bedruckten Substrats, der mit einem Tintenstrahl abgelagert wird, gemäß einem der vorigen Ansprüche, **dadurch gekennzeichnet, dass**
die Zusammensetzung des Firnis zumindest einen Zusatzstoff mit einer Korngröße unterhalb von 50µm enthält,
wobei dieser Zusatzstoff ist:
ein Mattiermittel zum Erzielen eines Matt- oder Satin-Firnis,
Plättchen zum Erzielen eines glitzernden Firnis,
Pigmente oder Farbstoffe zum Erzielen eines gefärbten Firnis,
fluoreszierende Pigmente oder Farbstoffe zum Erzielen eines fluoreszierenden Firnis und/oder
für Schwarzlicht empfindliche Pigmente oder Farbstoffe zum Erzielen eines Firnis mit optischem Effekt.

12. Firnis zum Bedecken der Oberfläche eines bedruckten Substrats, der mit einem Tintenstrahl abgelagert wird, gemäß einem der vorigen Ansprüche, **dadurch gekennzeichnet, dass** die Zusammensetzung des Firnis eine Korngröße enthält, die geeignet ist für den Durchgang durch eine Düse bei dem Ablagern über einen Tintenstrahl auf dem Substrat.

13. Verfahren zum Herstellen eines Firnis zum Bedecken der Oberfläche eines bedruckten Substrats, der mit einem Tintenstrahl abgelagert wird, gemäß einem der Ansprüche 2 bis 12, **dadurch gekennzeichnet, dass** das Verfahren enthält:
einen Schritt des Mischens des Viskositätsreduziermitteils mit dem Hemmstoff für freie Radikale und einem Fotoinitiator bei einer Temperatur, die zwischen 150 und 300°C, liegt,
einen Schritt des Abkühlens der Mischung bis auf eine Umgebungstemperatur,
einen Schritt des Hinzugebens unter Rühren zumindest eines härtbaren Oligomers gemäß der Zusammensetzung des Firnis und zumindest eines härtbaren Monomers gemäß der Zusammensetzung des Firnis.

14. Verfahren gemäß Anspruch 13 zum Herstellen eines Firnis zum Bedecken der Oberfläche eines bedruckten Substrats, der mit einem Tintenstrahl abgelagert wird, **dadurch gekennzeichnet, dass** das Verfahren enthält:
einen Schritt des Filterns der erhaltenen Mischung gemäß einer Korngröße, die geeignet ist für den Durchgang durch eine Düse bei dem Ablagern über einen Tintenstrahl auf dem Substrat.
